# EUROPEAN PATENT APPLICATION

(11) **EP 4 354 501 A1**
(43) Date of publication of application: **17.04.2024**
(21) Application number: 23202911.6
(22) Date of filing: 11.10.2023
(51) Int. Cl.: H01L 25/075, H01L 33/00, H01L 25/16

(54) **MAGNET UNIT OF SEMICONDUCTOR LIGHT EMITTING DEVICE FOR DISPLAY PIXEL AND SELF-ASSEMBLY DEVICE USING THE SAME**

(30) Priority: 14.10.2022 KR 20220132145
(71) Applicant: LG Electronics Inc., Yeongdeungpo-gu Seoul 07336 (KR)
(72) Inventor: BYUN, Yangwoo, 06772 Seoul (KR)
(74) Representative: Vossius & Partner Patentanwälte Rechtsanwälte mbB

(57) **Abstract**

The embodiment relates to a magnet unit (710) of a semiconductor light emitting device for a display pixel and a self-assembly device using the same.

A magnet unit (710) according to an embodiment includes a magnet body (702) and a magnet control unit (704) disposed around an outer circumference of the magnet body. The magnet control unit includes a first magnet focusing unit (704B) spaced apart from an outer circumference of the magnet body and a first spacer (704A) disposed between the magnet body (702) and the first magnet focusing unit (704B).

## Description

### BACKGROUND OF THE DISCLOSURE

### 1. Field of the Disclosure

Embodiment relates to a self-assembly device for semiconductor light emitting devices for display pixels. Specifically, the embodiment relates to a magnet unit capable of controlling the direction of a semiconductor light emitting device for a display pixel and a self-assembly device using the same.

### 2. Discussion of the Related Art

Technologies for implementing large-area displays include liquid crystal displays (LCDs), OLED displays, and micro-LED displays.

The micro-LED display is a display using micro-LED, which is a semiconductor light emitting device having a diameter or cross-sectional area of 100µm or less, as a display device.

Micro-LED display has excellent performance in many characteristics such as contrast ratio, response speed, color reproduction rate, viewing angle, brightness, resolution, lifespan, luminous efficiency and luminance because it uses micro-LED, which is a semiconductor light emitting device, as a display device.

In particular, micro-LED displays can separate and combine screens in a modular manner.

Accordingly, the micro-LED display has the advantage of freely adjusting the size or resolution and the advantage of being able to implement a flexible display.

However, there is a technical problem in that it is difficult to quickly and accurately transfer the semiconductor light emitting device to the display panel because more than millions of semiconductor light emitting devices are required for a large micro-LED display.

Transfer technologies that have been recently developed include a pick and place process, a laser lift-off method, or a self-assembly method.

Among these, the self-assembly method is a method in which a semiconductor light emitting device finds an assembly position in a fluid by itself, and is an advantageous method for realizing a large-screen display device.

Recently, although a micro-LED structure suitable for self-assembly has been proposed in US Patent No. 9,825,202, etc., research on a technology for manufacturing a display through self-assembly of micro-LEDs is still insufficient.

In particular, in the case of rapidly transferring millions or more semiconductor light emitting devices to a large display in the prior art, the transfer speed can be improved.

However, there is a technical problem in that the transfer error rate can increase and the transfer yield can decrease.

In internal technology, a self-assembly process using magnetism and dielectrophoresis (DEP) is being studied.

The self-assembly process of the internal technology proceeds in the order of surface treatment of the assembly substrate, loading of the assembly substrate, supply of semiconductor light emitting device chips, assembly and chip recovery, inspection, drying, and substrate separation.

The loading of the assembly substrate is a step of loading the assembly substrate into the substrate chuck, and the assembly substrate loaded into the substrate chuck is transferred to an assembly position in the assembly chamber. Thereafter, the magnetic field forming unit approaches the assembly substrate through vertical and horizontal movement.

In this state, a step of supplying the semiconductor light emitting device chip proceeds. Specifically, a step of dispersing the semiconductor light emitting device on the assembly surface of the assembly substrate is performed. When the semiconductor light emitting devices are dispersed near the assembly surface in a state where the magnetic field forming unit is sufficiently close to the assembly substrate, the semiconductor light emitting devices are adhered to the assembly surface by the magnetic field forming unit.

For example, according to internal technology, semiconductor light emitting device chips can be sequentially assembled into assembly pockets of an assembly substrate in a subsequent process while moving a group of semiconductor light emitting device chips including magnetic materials by a large number of rotating magnet rods.

For example, a self-assembly can be performed using DEP force, and a step of recovering the semiconductor light emitting device proceeds.

Finally, after self-assembly is complete, the assembly substrate can be inspected, dried, and separated from the substrate chuck.

Meanwhile, the uniform supply of semiconductor light emitting device chips to the assembly holes of the assembly substrate significantly affects assembly accuracy and assembly speed.

First, in the internal technology, assembly efficiency is improved by arranging a chip tray in an assembly chamber, supplying semiconductor light emitting device chips to the chip tray, and then uniformly providing semiconductor light emitting devices to an assembly substrate using the chip tray.

However, according to the internal technology, after supplying the semiconductor light emitting device to the chip tray, in the self-assembly process using magnetic force and DEP force, there is a problem of lowering the assembly rate due to the failure to control the direction of the semiconductor light emitting device chip for being assembled in the assembly hole of the assembly substrate.

Also, according to the internal technology, there are residual LED chips that are out of the LED chip cluster formed by the rotating magnet, since these residual LED chips are out of the control range by the magnet, there is a problem in that these residual LED chips may cause assembly defects, and a separate LED chip collection process is required later.

Also, in the self-assembly of semiconductor light emitting devices for display pixels of internal technology, in order to increase the assembly rate, research was conducted to lower the assembly speed, but due to the low assembly speed, a plurality of LED chips are assembled in one assembly hole, resulting in a contradictory situation in which incorrect assembly and residual LED chips increase.

### SUMMARY OF THE DISCLOSURE

One of the technical objects of the embodiment is to solve the problem that the assembly rate is lowered because the direction of the semiconductor light emitting device chip cannot be controlled for being assembled in the assembly hole of the assembly substrate in self-assembly.

Also, on the self-assembly of semiconductor light emitting devices for display pixels, there are residual LED chips out of the LED chip cluster formed by the rotating magnet, and since these residual LED chips are out of the control range by the magnet, one of the technical objects of the embodiment is to solve the problem of causing assembly defects and requiring a separate LED chip collection process later.

Also, one of the technical problems of the embodiment is that there are attempts of lowering the assembly speed in order to increase the assembly rate, but the lower assembly speed leads to a contradictory situation in which a plurality of LED chips are assembled in one assembly hole and the number of residual LED chips increases.

Accordingly, one of the technical objects of the embodiment is to improve the self-assembly characteristics by increasing the assembly speed by increasing the LED chip group movement speed and reducing the number of remaining LED chips in the assembly substrate.

The technical objects of the embodiment are not limited to those described in this section, but include those that can be understood throughout the specification.

The magnet unit of a semiconductor light emitting device for a display pixel according to the embodiment can include a magnet body and a magnet control unit disposed around an outer circumference of the magnet body.

The magnet control unit can include a first magnet focusing unit spaced apart from the outer circumference of the magnet body and a first spacer disposed between the magnet body and the first magnet focusing unit.

The magnet control unit can be disposed only on a part of the lower side of the magnet body. The magnet control unit can be disposed at a lower portion of the magnet body.

The first magnet focusing unit can include at least one of ferrite, nickel, iron, cobalt, or a nickel-cobalt alloy.

The spacer can include at least one of a plastic material, a fiber material, or a wood material.

The magnet control unit can be disposed around the lower and upper circumferences of the magnet body.

The magnet control unit can be disposed higher than lower and upper sides of the magnet body. The magnet control unit can extend higher than a top of the magnet body.

The embodiment can further include a double magnet control unit disposed on the outer circumference of the magnet control unit.

The double magnet control unit can include a double magnet focusing unit disposed spaced apart from the outer circumference of the magnet control unit and a double spacer disposed between the magnet control unit and the double magnet focusing unit.

The self-assembly device for a semiconductor light emitting device for a display pixel according to the embodiment can include a chamber accommodating a predetermined fluid

Also, the embodiment can include an assembly substrate disposed on the chamber and a magnet assembly device disposed on the assembly substrate.

The magnet assembly device can include a magnet support unit to which a plurality of magnet units are mounted, and a magnet rotation unit that rotates the magnet support unit.

The magnet unit can include a magnet body and a magnet control unit disposed around the outer circumference of the magnet body.

Also, the embodiment can include a self-assembly device for arranging a plurality of semiconductor light emitting devices on an assembly substrate, the self-assembly device comprising: a chamber configured to hold a fluid in which the plurality of semiconductor light emitting devices are disposed; and a magnet assembly device comprising a magnet support unit to which a plurality of magnet units are mounted and a magnet rotation unit configured to rotate rotating the magnet support unit.

Each magnet unit can comprise a magnet body and a magnet control unit disposed around an outer circumference of the magnet body.

The magnet assembly device is configured to generate a magnetic field to cause the plurality of semiconductor light emitting devices to be arranged on the assembly substrate disposed on the chamber.

The magnet control unit can include a first magnet focusing unit spaced apart from an outer circumference of the magnet body and a first spacer disposed between the magnet body and the first magnet focusing unit.

The magnet control unit can be disposed only on a part of the lower side of the magnet body.

The magnet control unit can be disposed around the lower and upper circumferences of the magnet body.

The magnet control unit can be disposed higher than lower and upper sides of the magnet body.

A double magnet control unit disposed outer circumference of the magnet control unit can be further included.

The double magnet control unit can include a double magnet focusing unit disposed spaced apart from the outer circumference of the magnet control unit and a double spacer disposed between the magnet control unit and the double magnet focusing unit.

According to the magnet unit of the semiconductor light emitting device for display pixels and the self-assembly device using the same according to the embodiment, in self-assembly of the semiconductor light emitting device for display pixels, there is a technical effect of improving the assembly rate by controlling the distribution and positioning direction of the semiconductor light emitting device by controlling the distribution and direction of the magnetic field near the assembly substrate so that the semiconductor light emitting device can be assembled in the assembly hole of the assembly substrate.

For example, according to the embodiment, by including one of the first magnet control unit 704 to the third magnet control unit 706 in the magnet units 710, 710B, 710C, and 710D, the direction of magnetic flux of the magnetic field applied to the semiconductor light emitting device chip can be controlled, so there is a special technical effect that can improve the speed of moving and assembling a group of semiconductor light emitting device chips by 2 to 3 times compared to internal technology.

For example, according to the embodiment, the first magnet unit (710) can include a first magnet focusing unit 704B fastened to the magnet body 702, and a first spacer 704A disposed between the magnet body 702 and the first magnet focusing unit 704B, so the direction of the magnetic flux of the magnetic field applied to the semiconductor light emitting device chips can be controlled in the horizontal direction (LFM). Therefore, the arrangement state of the semiconductor light emitting devices in the semiconductor light emitting device chip cluster can be controlled in parallel with the assembly substrate, there is a special technical effect that can significantly improve the assembly efficiency and improve the assembly speed by 2 to 3 times compared to the internal technology.

Also, according to the embodiment, by controlling the direction of the magnetic flux of the magnetic field applied to the semiconductor light emitting device chips in the horizontal direction (LFM), the arrangement state of the semiconductor light emitting devices in the semiconductor light emitting device chip cluster can be controlled in parallel with the assembly substrate.

For this reason, the embodiment has a special technical effect of improving the movement speed of the semiconductor light emitting device chip group by 2 to 3 times or more compared to the internal technology by lowering the resistance with the fluid and the resistance with the assembly substrate.

Also, according to the embodiment, there is a technical effect of improving assembly efficiency and omitting a separate LED chip collection process by preventing the generation of residual LED chips out of the LED chip cluster formed by the rotating magnet.

For example, in the embodiment, the magnet unit can include a first magnet focusing unit 704B fastened to the magnet body 702 and a first spacer 704A disposed between the magnet body 702 and the first magnet focusing unit 704B.

Therefore, the size GS of the semiconductor light emitting device cluster can be controlled by controlling the direction of the magnetic flux of the magnetic field applied to the semiconductor light emitting device chip in the horizontal direction (LFM) to clarify the boundary GB of the light emitting device cluster.

Also, according to the embodiment, the self-assembly characteristics can be improved by increasing the assembly speed through the increase in the LED chip cluster movement speed and reducing the number of remaining LED chips in the assembly substrate.

Also, in the embodiment, the fourth magnet unit 710D can include a magnet body 702, a first magnet control unit 704, and a fourth magnet control unit 707, as the fourth magnet focusing unit 707B of the fourth magnet control unit 707 controls permeability or width to be higher than that of the first magnet focusing unit 704B of the first magnet control unit 704, there is a special technical effect that can be adjusted to minimize the absolute Bz (z-direction magnetic field) at the bottom of the assembly substrate 200.

For example, the fourth magnet focusing unit 707B according to the embodiment can control its magnetic permeability or width to be higher than that of the first magnet focusing unit 704B, the magnetic flux density Bz2 in the Z-axis direction at the bottom of the assembly substrate 200 can be controlled to be minimized.

Therefore, the embodiment can control the direction of magnetic flux of the magnetic field applied to the semiconductor light emitting device chip in the horizontal direction more effectively to control the arrangement state of the semiconductor light emitting device in parallel with the assembly substrate, there is a special technical effect that significantly improves assembly speed and assembly efficiency.

The technical effects of the embodiments are not limited to those described in this section, but include those understood from the description of the invention.

### BRIEF DESCRIPTION OF THE DRAWINGS

FIG. 1 is an exemplary view of a living room of a house in which a display device according to an embodiment is disposed.
FIG. 2 is a block diagram schematically illustrating a display device according to an exemplary embodiment.
FIG. 3 is a circuit diagram showing an example of a pixel of FIG. 2.
FIG. 4 is an enlarged view of a first panel area of the display device of FIG. 1.
FIG. 5 is a cross-sectional view along line B 1-B2 of area A2 of FIG. 4.
FIG. 6 is an exemplary view in which a light emitting device according to an embodiment is assembled to a substrate by a self-assembly method.
FIG. 7 is a partially enlarged view of area A3 of FIG. 6.
FIG. 8 is a vertical perspective view of a magnet device 600 of a self-assembly device according to internal technology and a plan conceptual view of rotation and movement of the magnet device 600.
FIG. 9A is magnetic flux density data in the magnet device 600 shown in FIG. 8.
FIG. 9B is magnetic flux density data of a predetermined magnetic flux density range corresponding to the size of the cluster in the magnet device 600 shown in FIGS. 8 and 9.
FIG. 10 is a graph of vertical and horizontal magnetic flux densities in the magnet device 600 shown in FIG. 8
FIG. 11 is a conceptual diagram of a device 1000 for assembling a semiconductor light emitting device for a display pixel according to an embodiment.
FIG. 12 is a perspective view of the first magnet unit 710 in the device 1000 for assembling a semiconductor light emitting device for a display pixel according to an embodiment.
FIG. 13 is a perspective view of a first magnet control unit 704 in the first magnet unit 710 shown in FIG. 12.
FIG. 14A is a perspective view of a second magnet unit 710B in an embodiment.
FIG. 14B is a perspective view of a third magnet unit 710C in an embodiment.
FIG. 15A is magnetic flux density data in the first magnet unit 710 shown in FIG. 12.
FIG. 15B is magnetic flux density data of a predetermined magnetic flux density range corresponding to the size of the cluster in the magnet device 600 shown in FIGS. 12 and 15A.
FIG. 15C is an enlarged view of the first horizontal magnetic flux area (LMF1) in FIG. 15B.
FIG. 16 is a graph of vertical and horizontal magnetic flux densities in the magnet device 600 shown in FIGS. 12 and 15A.
FIG. 17 is a conceptual diagram illustrating rotation of a magnet unit 710 and distribution and movement of a group of semiconductor light emitting devices in the device 1000 for assembly semiconductor light emitting devices for display pixels according to an embodiment.
FIG. 18 is a perspective view of a fourth magnet unit 710D in the device 1000 for assembling a semiconductor light emitting device for a display pixel according to an embodiment.
FIG. 19 is a graph of vertical and horizontal magnetic flux densities in Examples and Comparative Examples adopting a fourth magnet unit 710D.
FIG. 20A is magnetic flux density data in the fourth magnet unit 710D shown in FIG. 18.
FIG. 20B is an enlarged view of the second horizontal magnetic flux area LMF2 in FIG. 20A.

### DETAILED DESCRIPTION OF THE EMBODIMENTS

Hereinafter, embodiments disclosed in the present description will be described in detail with reference to the accompanying drawings. The suffixes 'module' and 'part' for components used in the following description are given or mixed in consideration of ease of specification, and do not have a meaning or role distinct from each other by themselves. Also, the accompanying drawings are provided for easy understanding of the embodiments disclosed in the present specification, and the technical ideas disclosed in the present specification are not limited by the accompanying drawings. Also, when an element, such as a layer, area, or substrate, is referred to as being 'on' another component, this includes that it is directly on the other element or there can be other intermediate elements in between.

The display device described in this specification can include a digital TV, a mobile phone, a smart phone, a laptop computer, a digital broadcasting terminal, a personal digital assistant (PDA), a portable multimedia player (PMP), a navigation, a Slate PC, a Tablet PC, an Ultra-Book, a desktop computer, and the like.

However, the configuration according to the embodiment described in this specification can be applied to a device capable of displaying even a new product type to be developed in the future.

Hereinafter, a light emitting device and a display device including the light emitting device according to the embodiment will be described.

Hereinafter, an assembly substrate structure of a semiconductor light emitting device display device according to an embodiment and a display device including the same will be described.

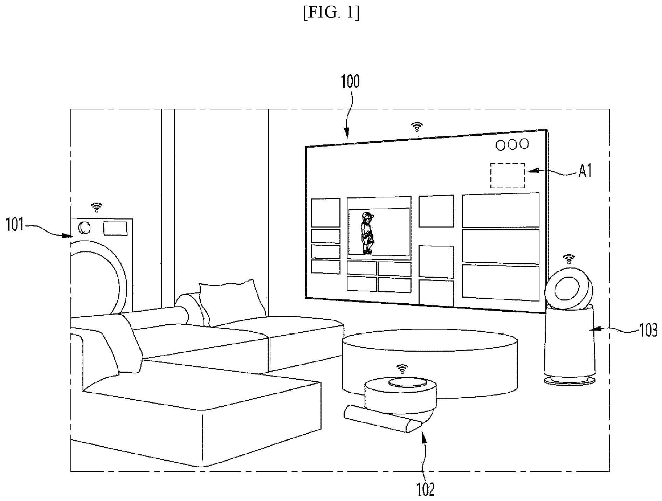

FIG. 1 shows a living room of a house in which a display device 100 according to an embodiment is disposed.

The display device 100 of the embodiment can display the status of various electronic products such as the washing machine 101, the robot cleaner 102, and the air purifier 103, and communicate with each electronic product based on IOT, and can control each electronic product based on the user's setting data.

The display device 100 according to the embodiment can include a flexible display manufactured on a thin and flexible substrate.

The flexible display can be bent or rolled like paper while maintaining the characteristics of a conventional flat panel display.

In the flexible display, visual information can be implemented by independently controlling light emission of unit pixels arranged in a matrix form. A unit pixel means a minimum unit for realizing one color. The unit pixel of the flexible display can be implemented by a light emitting device. In an embodiment, the light emitting device can be a Micro-LED or a Nano-LED, but is not limited thereto.

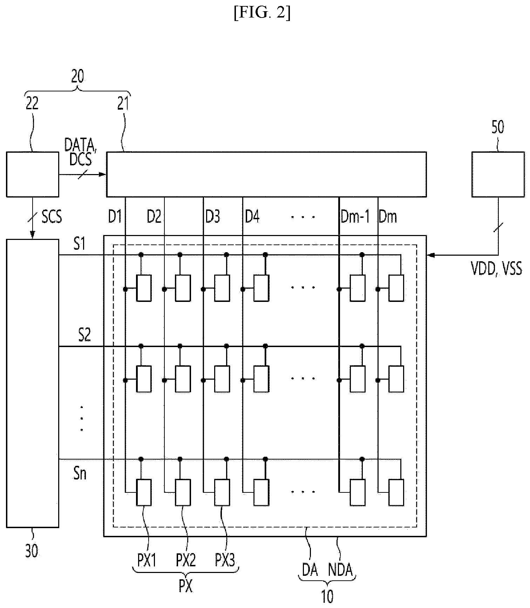

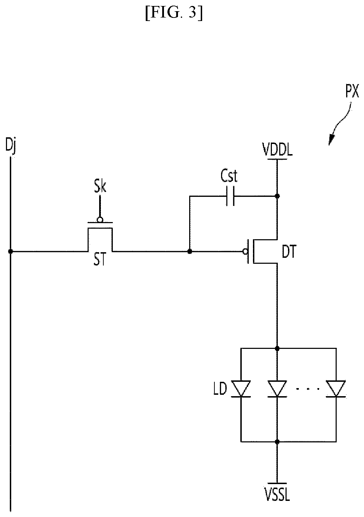

Next, FIG. 2 is a block diagram schematically showing a display device according to an embodiment, and FIG. 3 is a circuit diagram showing an example of the pixel of FIG. 2. Referring to FIGS. 2 and 3, the display device according to the embodiment can include a display panel 10, a driving circuit 20, a scan driving unit 30, and a power supply circuit 50.

The display device 100 according to the embodiment can drive the light emitting device using an active matrix (AM) method or a passive matrix (PM, passive matrix) method.

The driving circuit 20 can include a data driving unit 21 and a timing control unit 22.

The display panel 10 can be divided into a display area DA and a non-display area NDA disposed around the display area DA. The display area DA is an area in which pixels PX are formed to display an image. The display panel 10 can include data lines (D1 to Dm, m is an integer greater than or equal to 2), scan lines crossing the data lines D1 to Dm (S1 to Sn, n is an integer greater than or equal to 2), the high-potential voltage line supplied with the high-voltage, the low-potential voltage line supplied with the low-potential voltage, and the pixels PX connected to the data lines D1 to Dm and the scan lines S1 to Sn can be included.

Each of the pixels PX can include a first sub-pixel PX1, a second sub-pixel PX2, and a third sub-pixel PX3. The first sub-pixel PX1 emits a first color light of a first wavelength, the second sub-pixel PX2 emits a second color light of a second wavelength, and the third sub-pixel PX3 emits a third color light of a wavelength can be emitted. The first color light can be red light, the second color light can be green light, and the third color light can be blue light, but is not limited thereto. Also, although it is illustrated that each of the pixels PX includes three sub-pixels in FIG. 2, the present invention is not limited thereto. That is, each of the pixels PX can include four or more sub-pixels.

Each of the first sub-pixel PX1, the second sub-pixel PX2, and the third sub-pixel PX3 can be connected to at least one of the data lines D1 to Dm, and at least one of the scan lines S1 to Sn, and a high potential voltage line. As shown in FIG. 3, the first sub-pixel PX1 can include the light emitting devices LD, plurality of transistors for supplying current to the light emitting devices LD, and at least one capacitor Cst.

Although not shown in the drawing, each of the first sub-pixel PX1, the second sub-pixel PX2, and the third sub-pixel PX3 can include only one light emitting device LD and at least one capacitor Cst.

Each of the light emitting devices LD may be a semiconductor light emitting diode including a first electrode, a plurality of conductivity type semiconductor layers, and a second electrode. Here, the first electrode can be an anode electrode and the second electrode can be a cathode electrode, but the present invention is not limited thereto.

Referring to FIG. 3, the plurality of transistors can include a driving transistor DT for supplying current to the light emitting devices LD, and a scan transistor ST for supplying a data voltage to the gate electrode of the driving transistor DT. The driving transistor DT can include a gate electrode connected to the source electrode of the scan transistor ST, a source electrode connected to a high potential voltage line to which a high potential voltage is applied, and a drain electrode connected to first electrodes of the light emitting devices LD. The scan transistor ST can include a gate electrode connected to the scan line Sk, where k is an integer satisfying 1≤k≤n, a source electrode connected to the gate electrode of the driving transistor DT, and a drain electrode connected to data lines Dj, where j is integer satisfying 1≤j≤m.

The capacitor Cst can be formed between the gate electrode and the source electrode of the driving transistor DT. The storage capacitor Cst can charge a difference between the gate voltage and the source voltage of the driving transistor DT.

The driving transistor DT and the scan transistor ST can be formed of a thin film transistor. Also, although the driving transistor DT and the scan transistor ST have been mainly described in FIG. 3 as being formed of a P-type MOSFET (Metal Oxide Semiconductor Field Effect Transistor), the present invention is not limited thereto. The driving transistor DT and the scan transistor ST can be formed of an N-type MOSFET. In this case, the positions of the source electrode and the drain electrode of each of the driving transistor DT and the scan transistor ST can be changed.

Also, in FIG. 3, each of the first sub-pixel PX1, the second sub-pixel PX2, and the third sub-pixel PX3 is illustrated as including one driving transistor DT, one scan transistor ST, and 2T1C (2 Transistor -1 capacitor) having a capacitor Cst, but the present invention is not limited thereto. Each of the first sub-pixel PX1, the second sub-pixel PX2, and the third sub-pixel PX3 can include a plurality of scan transistors ST and a plurality of capacitors Cst.

Referring back to FIG. 2, the driving circuit 20 outputs signals and voltages for driving the display panel 10. To this end, the driving circuit 20 can include a data driver 21 and a timing controller 22.

The data driver 21 receives digital video data DATA and a source control signal DCS from the timing controller 22. The data driver 21 converts the digital video data DATA into analog data voltages according to the source control signal DCS and supplies them to the data lines D 1 to Dm of the display panel 10.

The timing controller 22 receives digital video data DATA and timing signals from the host system. The timing signals can include a vertical sync signal, a horizontal sync signal, a data enable signal, and a dot clock. The host system may be an application processor of a smartphone or tablet PC, a monitor, or a system-on-chip of a TV.

The scan driver 30 receives the scan control signal SCS from the timing controller 22. The scan driver 30 generates scan signals according to the scan control signal SCS and supplies them to the scan lines S1 to Sn of the display panel 10. The scan driver 30 can include a plurality of transistors and can be formed in the non-display area NDA of the display panel 10. Also, the scan driver 30 can be formed of an integrated circuit, and in this case, can be mounted on a gate flexible film attached to the other side of the display panel 10.

The power supply circuit 50 generates a high potential voltage VDD and a low potential voltage VSS for driving the light emitting devices LD of the display panel 10 from the main power source, and the power supply circuit can supply VDD and VSS to the high-potential voltage line and the low-potential voltage line of the display panel 10. Also, the power supply circuit 50 can generate and supply driving voltages for driving the driving circuit 20 and the scan driving unit 30 from the main power.

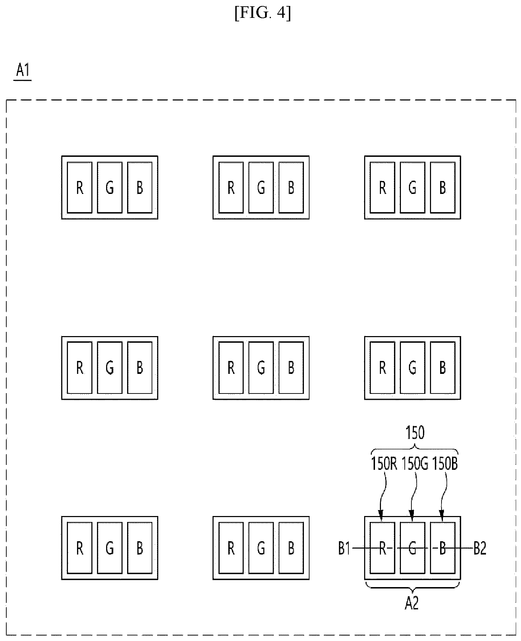

Next, FIG. 4 is an enlarged view of the first panel area A1 in the display device of FIG. 1.

Referring to FIG. 4, the display device 100 according to the embodiment can be manufactured by mechanically and electrically connecting a plurality of panel areas such as the first panel area A1 by tiling.

The first panel area A1 can include a plurality of light emitting devices 150 arranged for each unit pixel (PX in FIG. 2).

For example, the unit pixel PX can include a first sub-pixel PX1, a second sub-pixel PX2, and a third sub-pixel PX3. For example, a plurality of red light emitting devices 150R are disposed in the first sub-pixel PX1, a plurality of green light emitting devices 150G are disposed in the second sub-pixel PX2, and a plurality of blue light emitting devices 150B are disposed in the third sub-pixel PX3. The unit pixel PX can further include a fourth sub-pixel in which a light emitting device is not disposed, but is not limited thereto. Meanwhile, the light emitting device 150 may be the semiconductor light emitting device.

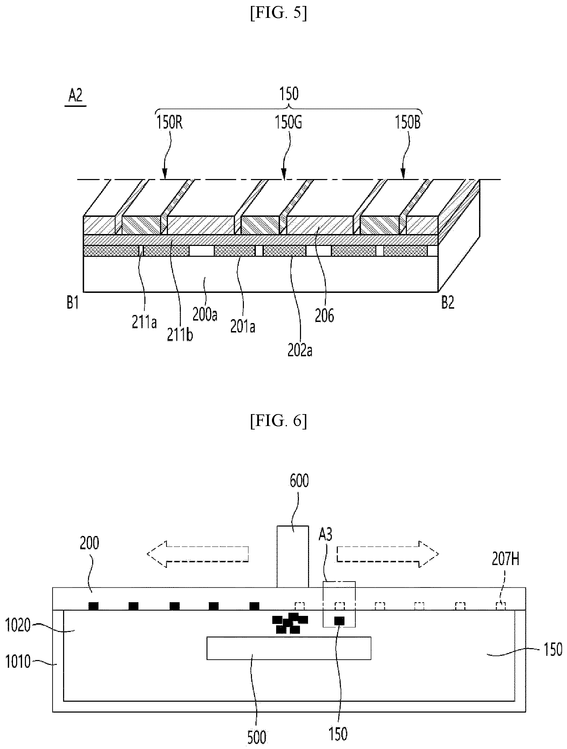

Next, FIG. 5 is a cross-sectional view taken along line B1-B2 of area A2 of FIG. 4.

Referring to FIG. 5, the display device 100 of the embodiment can include a substrate 200a, wirings 201a and 202a spaced apart from each other, a first insulating layer 211a, a second insulating layer 211b, a third insulating layer 206 and a plurality of light emitting devices 150.

The wiring can include a first wiring 201a and a second wiring 202a spaced apart from each other. The first wiring 201a and the second wiring 202a can function as panel wiring for applying power to the light emitting device 150 in the panel, and in the case of self-assembly of the light emitting device 150, also, the first wiring 201a and the second wiring 202a can function as an assembly electrode for generating a dielectrophoresis force.

The wirings 201a and 202a can be formed of a transparent electrode (ITO) or include a metal material having excellent electrical conductivity. For example, the wirings 201a and 202a can be formed at least one of titanium (Ti), chromium (Cr), nickel (Ni), aluminum (Al), platinum (Pt), gold (Au), tungsten (W), molybdenum (Mo) or an alloy thereof.

A first insulating layer 211a can be disposed between the first wiring 201a and the second wiring 202a, and a second insulating layer 211b can be disposed on the first wiring 201a and the second wiring 202a. The first insulating layer 211a and the second insulating layer 211b can be an oxide film, a nitride film, or the like, but are not limited thereto.

The light emitting device 150 can include a red light emitting device 150R, a green light emitting device 150G, and a blue light emitting device 150B0 to form a sub-pixel, respectively, but is not limited thereto. The light emitting device 150 can include a red phosphor and a green phosphor to implement red and green, respectively.

The substrate 200a can be formed of glass or polyimide. Also, the substrate 200a can include a flexible material such as polyethylene naphthalate (PEN) or polyethylene terephthalate (PET). Also, the substrate 200 can include a transparent material, but is not limited thereto. The substrate 200a can function as a support substrate in the panel, and can function as a substrate for assembly when self-assembling the light emitting device.

The third insulating layer 206 can include an insulating and flexible material such as polyimide, PEN, or PET, and can be integrally formed with the substrate 200a to form one substrate.

The third insulating layer 206 can be a conductive adhesive layer having adhesiveness and conductivity, and the conductive adhesive layer can be flexible to enable a flexible function of the display device. For example, the third insulating layer 206 can be an anisotropy conductive film (ACF) or a conductive adhesive layer such as an anisotropic conductive medium or a solution containing conductive particles. The conductive adhesive layer can be a layer that is electrically conductive in a direction perpendicular to the thickness but electrically insulating in a direction horizontal to the thickness.

The distance between the first and second wirings 201a and 202a is formed to be smaller than the width of the light emitting device 150 and the width of the assembly hole 207H, so that the assembly position of the light emitting device 150 using an electric field can be more precisely fixed.

A third insulating layer 206 is formed on the first and second wirings 201a and 202a to protect the first and second wirings 201a and 202a from the fluid 1020, and the third insulating layer 206 is can prevent leakage of current flowing through the two wirings 201a and 202a. The third insulating layer 206 can be formed of a single layer or multiple layers of an inorganic insulator such as silica or alumina or an organic insulator.

Also, the third insulating layer 206 can include an insulating and flexible material such as polyimide, PEN, PET, etc., and can be formed integrally with the substrate 200 to form a single substrate.

The third insulating layer 206 has a barrier wall, and an assembly hole 207H can be formed by the barrier wall. For example, the third insulating layer 206 can include an assembly hole 207H through which the light emitting device 150 is inserted (refer to FIG. 6). Accordingly, during self-assembly, the light emitting device 150 can be easily inserted into the assembly hole 207H of the third insulating layer 206. The assembly hole 207H can be referred to as an insertion hole, a fixing hole, or an alignment hole.

The assembly hole 207H can have a shape and size corresponding to the shape of the light emitting device 150 to be assembled at the corresponding position.

Accordingly, it is possible to prevent assembly of other light emitting elements or assembly of a plurality of light emitting elements into the assembly hole 207H.

Next, FIG. 6 is a view showing an example in which a light emitting device according to an embodiment is assembled to a substrate by a self-assembly method.

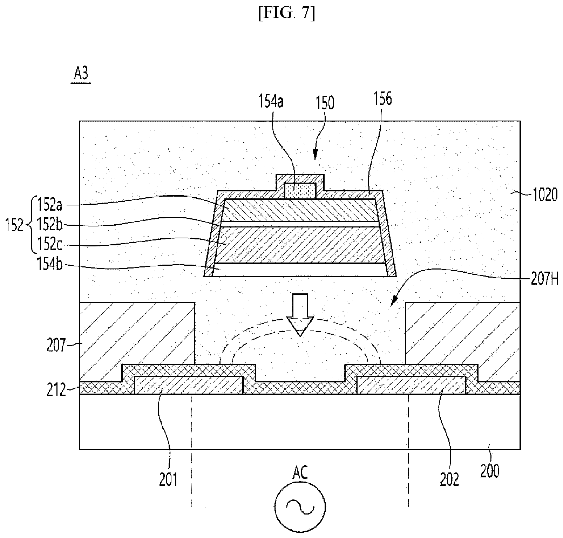

FIG. 7 is a partially enlarged view of area A3 of FIG. 6. 7 is a diagram showing a state in which area A3 is rotated 180 degrees for convenience of description.

An example of assembling the semiconductor light emitting device according to the embodiment to a display panel by a self-assembly method using an electromagnetic field will be described based on FIGS. 6 and 7.

The assembly substrate 200 described below can also function as a panel substrate 200a in a display device after assembling a light emitting device, but the embodiment is not limited thereto.

Referring to FIG. 6, the semiconductor light emitting device 150 can be put into a chamber 1010 filled with a fluid 1020 and can move to the assembly substrate 200 while forming the semiconductor light emitting devices 150G in a cluster form by the magnetic field generated from the magnet device 600 having magnetic force. At this time, the light emitting device 150 adjacent to the assembly hole 207H of the assembly substrate 200 can be assembled into the assembly hole 207H by DEP force generated by the electric field of the assembly electrodes. The fluid 1020 can be water such as ultrapure water, but is not limited thereto. A chamber can also be called a water bath, container, vessel, or the like.

After the semiconductor light emitting device 150 is put into the chamber 1010, the assembly substrate 200 can be disposed on the chamber 1010.

Depending on the embodiment, the assembly substrate 200 can be put into the chamber 1010.

In the internal technology, after arranging the chip tray 500 in the assembly chamber and supplying the semiconductor light emitting device chips 150G to the chip tray, the chip tray 500 is used to uniformly provide semiconductor light emitting devices to the assembly substrate to improve assembly efficiency.

Next, referring to FIG. 7, the semiconductor light emitting device 150 can be implemented as a vertical type semiconductor light emitting device as shown, but is not limited thereto and a horizontal type light emitting device can be adopted.

The semiconductor light emitting device 150 can include a magnetic layer 154b having a magnetic material. The magnetic layer 154b can include a metal having magnetism, such as nickel, cobalt, or iron. Since the semiconductor light emitting device 150 injected into the fluid includes the magnetic layer 154b, it can move to the assembly substrate 200 by the magnetic field generated from the magnet device 600.

The semiconductor light emitting device 150 can include a passivation layer 156 surrounding the top and side surfaces. The passivation layer 156 can be formed by using an inorganic insulator such as silica or alumina through PECVD, LPCVD, sputtering deposition, or the like. Also, the passivation layer 156 can be formed through a method of spin coating an organic material such as a photoresist or a polymer material.

The semiconductor light emitting device 150 can include a first conductivity type semiconductor layer 152a, a second conductivity type semiconductor layer 152c, and an active layer 152b disposed between the first conductivity type semiconductor layer 152a and the second conductivity type semiconductor layer 152c. The first conductivity type semiconductor layer 152a can be an n-type semiconductor layer, and the second conductivity type semiconductor layer 152c can be a p-type semiconductor layer, but is not limited thereto.

A first electrode layer 154a can be disposed on the first conductivity type semiconductor layer 152a, and a second electrode layer 154b can be disposed on the second conductivity type semiconductor layer 152c. To this end, a partial area of the first conductivity type semiconductor layer 152a or the second conductivity type semiconductor layer 152c can be exposed to the outside. Accordingly, after the semiconductor light emitting device 150 is assembled on the assembly substrate 200, a portion of the passivation layer 156 can be etched in the manufacturing process of the display device.

The assembly substrate 200 can include a pair of first assembly electrodes 201 and second assembly electrodes 202 corresponding to each of the semiconductor light emitting devices 150 to be assembled. The first assembly electrode 201 and the second assembly electrode 202 can be formed by stacking a single metal, a metal alloy, or a metal oxide in multiple layers. For example, the first assembly electrode 201 and the second assembly electrode 202 can be formed including at least one of Cu, Ag, Ni, Cr, Ti, Al, Rh, Pd, Ir, Ru, Mg, Zn, Pt, Au, or Hf, but is not limited thereto.

Also, the first assembly electrode 201 and the second assembly electrode 202 can be formed including at least one of indium tin oxide (ITO), indium zinc oxide (IZO), indium zinc tin oxide (IZTO), indium aluminum zinc oxide (IAZO), IGZO (indium gallium zinc oxide), IGTO (indium gallium tin oxide), AZO (aluminum zinc oxide), ATO (antimony tin oxide), GZO (gallium zinc oxide), IZON (IZO Nitride), AGZO (Al-Ga ZnO), IGZO (In-Ga ZnO), ZnO, IrOx, RuOx, NiO, RuOx/ITO, Ni/IrOx/Au, or Ni/IrOx/Au/ITO, and is not limited thereto.

The first assembly electrode 201, the second assembly electrode 202 emits an electric field as an AC voltage is applied, the semiconductor light emitting device 150 inserted into the assembly hole 207H can be fixed by dielectrophoretic force. A distance between the first assembly electrode 201 and the second assembly electrode 202 can be smaller than a width of the semiconductor light emitting device 150 and a width of the assembly hole 207H, the assembly position of the semiconductor light emitting device 150 using the electric field can be more precisely fixed.

An insulating layer 212 is formed on the first assembly electrode 201 and the second assembly electrode 202 to protect the first assembly electrode 201 and the second assembly electrode 202 from the fluid 1020 and leakage of current flowing through the first assembly electrode 201 and the second assembly electrode 202 can be prevented. For example, the insulating layer 212 can be formed of a single layer or multiple layers of an inorganic insulator such as silica or alumina or an organic insulator. The insulating layer 212 can have a minimum thickness to prevent damage to the first assembly electrode 201 and the second assembly electrode 202 when the semiconductor light emitting device 150 is assembled, and it can have a maximum thickness for the semiconductor light emitting device 150 being stably assembled.

A barrier wall 207 can be formed on the insulating layer 212. A portion of the barrier wall 207 can be positioned on the first assembly electrode 201 and the second assembly electrode 202, and the remaining area can be positioned on the assembly substrate 200.

On the other hand, when the assembly substrate 200 is manufactured, a portion of the barrier walls formed on the entire upper portion of the insulating layer 212 is removed, an assembly hole 207H in which each of the semiconductor light emitting devices 150 is coupled and assembled to the assembly substrate 200 can be formed.

An assembly hole 207H to which the semiconductor light emitting devices 150 are coupled is formed in the assembly substrate 200, and a surface on which the assembly hole 207H is formed can be in contact with the fluid 1020. The assembly hole 207H can guide an accurate assembly position of the semiconductor light emitting device 150.

Meanwhile, the assembly hole 207H can have a shape and size corresponding to the shape of the semiconductor light emitting device 150 to be assembled at the corresponding position.

Accordingly, assembly of another semiconductor light emitting device or assembly of a plurality of semiconductor light emitting devices into the assembly hole 207H can be prevented.

Referring back to FIG. 6, after the assembly substrate 200 is immersed in the fluid of the chamber, the magnet device 600 applying a magnetic field can move along the assembly substrate 200. The magnet device 600 can be a permanent magnet such as a neodymium magnet or an electromagnet.

The magnet device 600 can move in a state of being in contact with the assembly substrate 200 in order to maximize the area of the magnetic field into the fluid 1020. Depending on the embodiment, the magnet device 600 can include a plurality of magnetic bodies or can include a magnetic body having a size corresponding to that of the assembly substrate 200. In this case, the movement distance of the magnet device 600 can be limited within a predetermined range.

The semiconductor light emitting device 150 in the chamber 1010 can move toward the magnet device 600 and the assembly substrate 200 by the magnetic field generated by the magnet device 600.

Referring to FIG. 7, while moving toward the magnet device 600, the semiconductor light emitting device 150 can enter into the assembly hole 207H and be fixed by a dielectrophoretic force (DEP force) generated by the electric field of the assembly electrode of the assembly substrate.

Specifically, the first and second assembly wires 201 and 202 form an electric field by an AC power source, and a dielectrophoretic force can be formed between the assembly wires 201 and 202 by the electric field. The semiconductor light emitting device 150 can be fixed to the assembly hole 207H on the assembly substrate 200 by this dielectrophoretic force.

At this time, a predetermined solder layer (not shown) can be formed between the assembly electrode and the light emitting device 150 assembled on the assembly hole 207H of the assembly substrate 200 to improve the bonding strength of the light emitting device 150.

After assembling, a molding layer (not shown) can be formed in the assembly hole 207H of the assembly substrate 200.

The molding layer may be a transparent resin or a resin containing a reflective material or a scattering material.

The self-assembly method using the electromagnetic field described above can drastically reduce the time required to assemble each of the semiconductor light emitting devices to the substrate.

Accordingly, a large-area high-pixel display can be implemented more quickly and economically.

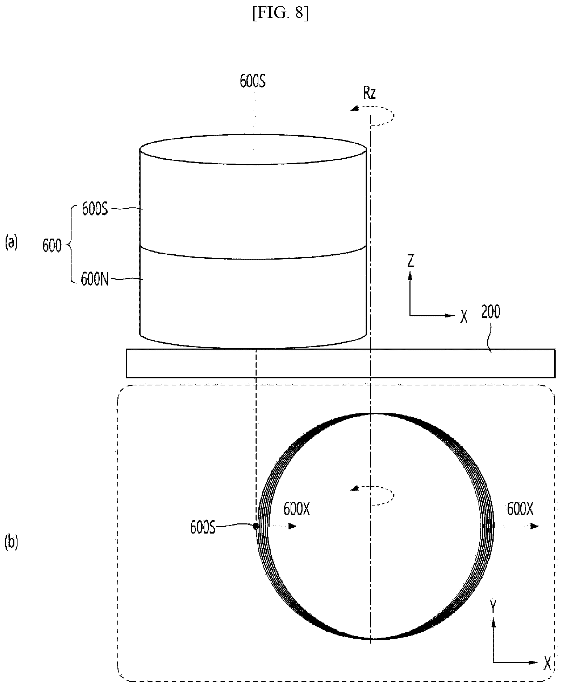

First, technical problems in self-assembly of a semiconductor light emitting device for a display pixel according to an internal technology will be described with reference to FIGS. 8 to 10.

FIG. 8 is a perspective view for a semiconductor light emitting device self-assembly device for display pixels according to internal technology. In detail, FIG. 8 includes a vertical perspective view (refer to FIG. 8(a)) of the rotating magnet device 600 disposed on the assembly substrate 200 and a plan conceptual view of rotation and movement (600X) of the magnet device 600 (refer to FIG. 8(b)).

Referring to FIG. 8 (a), in the self-assembly device for semiconductor light emitting devices for display pixels according to the internal technology, the magnet device 600 shows a permanent magnet as an example, and includes an N-pole magnet area 600A and a S-pole magnet area 600B, and can rotate around a predetermined rotational axis Rz.

Referring to FIG. 8 (b), the magnet device 600 can move in the first direction 600X of the X axis while the center 600S of the magnet rotates counterclockwise (or clockwise) around the rotation axis Rz.

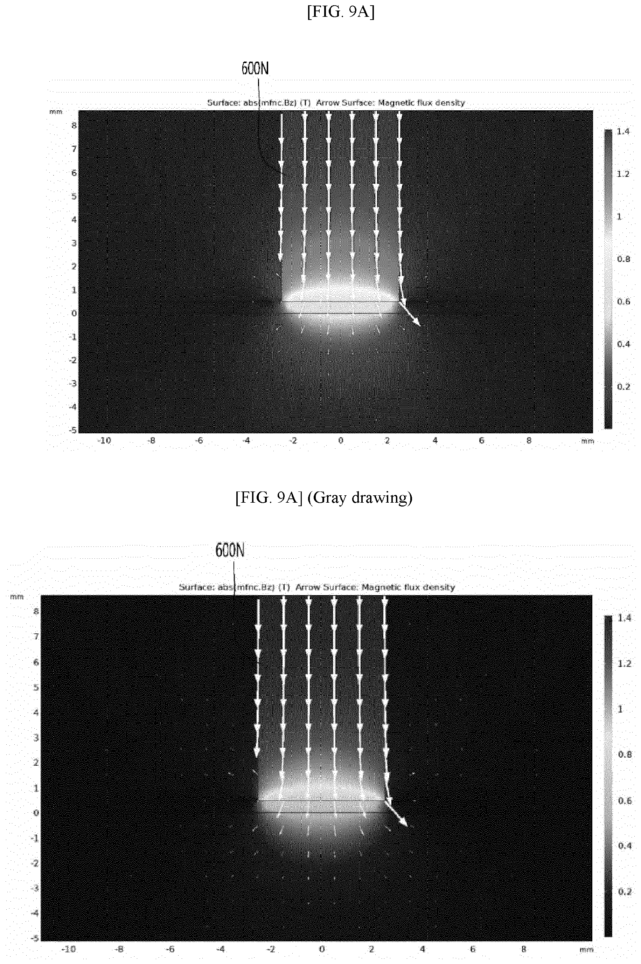

Next, FIG. 9A is magnetic flux density data in the magnet device 600 shown in FIG. 8.

Specifically, FIG. 9A is magnetic flux density data in the Z-axis direction (vertical direction) among magnetic flux densities in the magnet device 600 shown in FIG. 8.

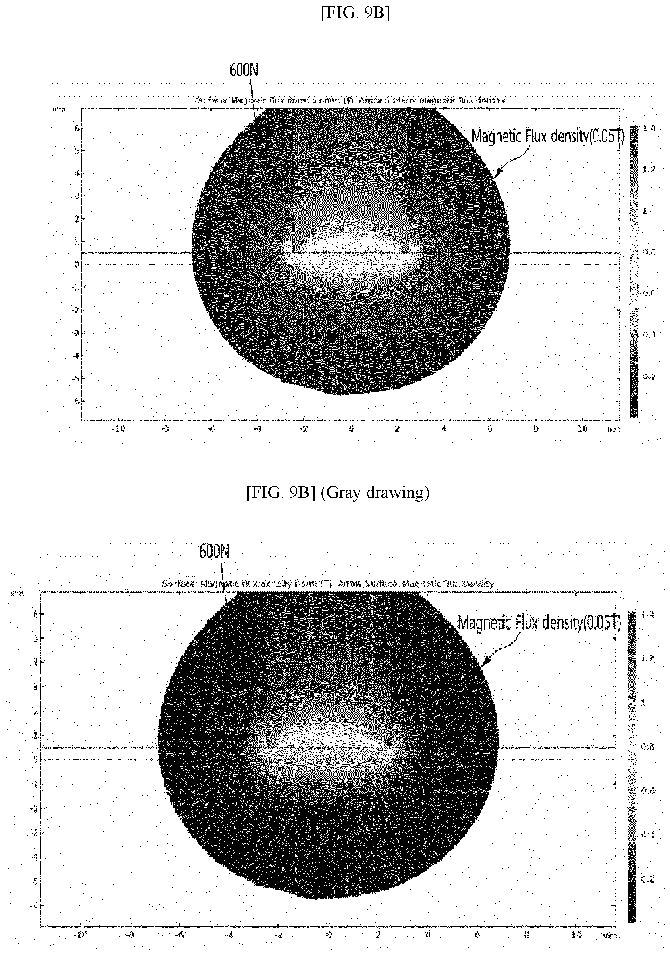

Also, FIG. 9B is magnetic flux density data of a predetermined magnetic flux density range corresponding to the size of the cluster in the magnet device 600 shown in FIGS. 8 and 9.

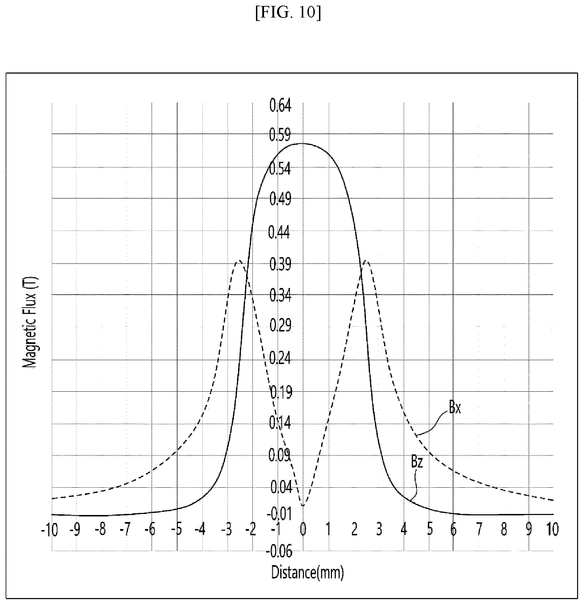

Specifically, FIG. 9B is a graph of magnetic flux density data for an area in which the magnetic flux density is about 0.05 T in the magnet device 600 shown in FIGS. 8 and 10.

Also, FIG. 10 is a graph of vertical and horizontal magnetic flux densities in the magnet device 600 shown in FIG. 8.

Specifically, FIG. 10 is a graph of magnetic flux density (Bz) in the Z-axis direction (vertical direction) and magnetic flux density (Bx) in the horizontal direction among magnetic flux densities in the magnet device 600 shown in FIG. 9A.

According to the internal technology, in the case of the rotating magnet of the internal technology, a single magnet rotates clockwise or counterclockwise and moves.

However, it is difficult to improve the mobility of a group of LED chips compared to the same rotational speed with the rotating magnet of the internal technology.

Specifically, in the self-assembly equipment according to the internal technology, a large number of rotating magnet rods move a cluster of semiconductor light emitting devices including magnetic layers so that the semiconductor light emitting devices are assembled into an assembly hole of an assembly substrate.

However, in the self-assembly equipment of the internal technology, the method of supplying the LED chip to the assembly substrate is to place an LED chip with a magnetic layer on the lower side of the assembly substrate, place a rotating magnet on the upper side of the assembly substrate, and then move the rotating magnet in the X, Y horizontal directions to move the LED chip to the vicinity of the assembly hole of the assembly substrate.

After that, a method of assembling LED chips into the assembly hole of the assembly substrate by applying DEP force is used.

However, the rotating magnet of the internal technology is a concept that rotates and moves in a clockwise or counterclockwise direction.

In this method, it is difficult to improve the mobility of the LED chip group compared to the rotation speed.

In particular, according to the internal technology, in a cluster of LED chips moved near the assembly hole of the assembly substrate by a rotating magnet, the state of the individual LED chips is arranged in the fluid in the direction of the magnetic flux of the magnet.

For example, referring to FIGS. 9A, 9B, and 10, since the vertical magnetic flux (Bz) is maintained at a significant level, when an LED chip is positioned vertically or tilted on an assembly substrate, an assembly defect occurs in which two or three LED chips in a vertical state are assembled at once into an assembly hole.

Also, according to the internal technology, there can be residual LED chips out of the LED chip cluster formed by the rotating magnet.

Since these residual LED chips are out of the control range by the magnet, they cause assembly defects, and there is a problem in that a separate LED chip collection process is required later.

Particularly, when a cluster of LED chips is formed by a rotating magnet, friction between the LED chips and the assembly substrate can occur due to the vertical magnetic field Bz.

Also, there is a problem of lowering the moving speed and assembly speed of the LED chip.

Also, there is a problem in that already assembled LED chips are separated by the impact of the moving LED chips.

Also, fluid resistance can occur depending on the shape of the distribution of the LED chips when the LED chips are moved by the vertical magnetic field (Bz) of the rotating magnet.

Hereinafter, a magnet unit capable of controlling a direction of a semiconductor light emitting device for a display pixel and a self-assembly device using the same according to an embodiment for solving the above technical problem will be described.

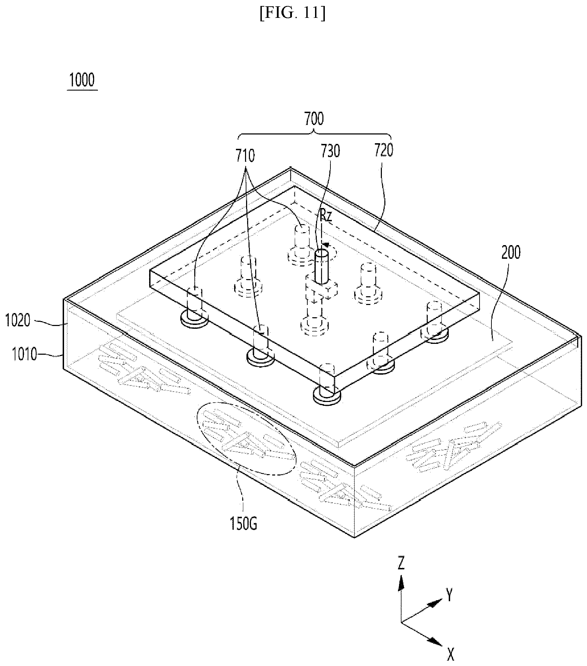

FIG. 11 is a conceptual diagram of a device 1000 for assembling a semiconductor light emitting device for a display pixel according to an embodiment.

The device 1000 for assembling a semiconductor light emitting device for a display pixel according to the embodiment can include a chamber 1010, a fluid 1020 in which a cluster of semiconductor light emitting devices 150G is dispersed, an assembly substrate 200, and a magnet assembly device 700.

The magnet assembly device 700 can include a first magnet unit 710, a magnet support unit 720, and a magnet rotation unit 730.

A plurality of first magnet units 710 can be mounted on the magnet support unit 720, and as the magnet rotation unit 730 rotates the magnet support unit 720 around the rotation axis Rz, a plurality of first magnet units 710 can rotate simultaneously, but is not limited thereto.

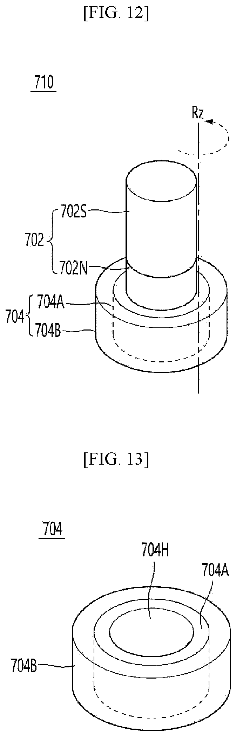

FIG. 12 is a perspective view of a first magnet unit 710 in an assembly device 1000 for a semiconductor light emitting device for a display pixel according to an embodiment. FIG. 13 is a perspective view of the first magnet control unit 704 in the first magnet unit 710 shown in FIG. 12.

Referring to FIG. 12, the first magnet unit 710 can include a magnet body 702 and a first magnet control unit 704. The magnet body 702 can include an N pole part 702N and an S pole part 702S. The N pole part 702N can be disposed below the S pole part 702S, but is not limited thereto.

The first magnet control unit 704 can include a first magnet focusing unit 704B coupled to the magnet body 702 and a first spacer 704A disposed between the magnet body 702 and the first magnet focusing unit 704B.

The first magnet control unit 704 can be disposed only on a part of the lower side of the magnet body 702.

For example, the first magnet control unit 704 can be disposed in a form surrounding only a part of the N-pole part 702N of the magnet body 702, but is not limited thereto.

The first magnet focusing unit 704B can be a ring-shaped metal socket made of a material having high magnetic permeability, but is not limited thereto. For example, the first magnet focusing unit 704B can include one or more of ferrite, nickel, iron, cobalt, and a nickel-cobalt alloy, but is not limited thereto.

The first spacer 704A may be made of a non-metallic material having low magnetic permeability.

For example, the first spacer 704A can be a plastic material, a fiber material, or a wood material having excellent heat resistance, but is not limited thereto.

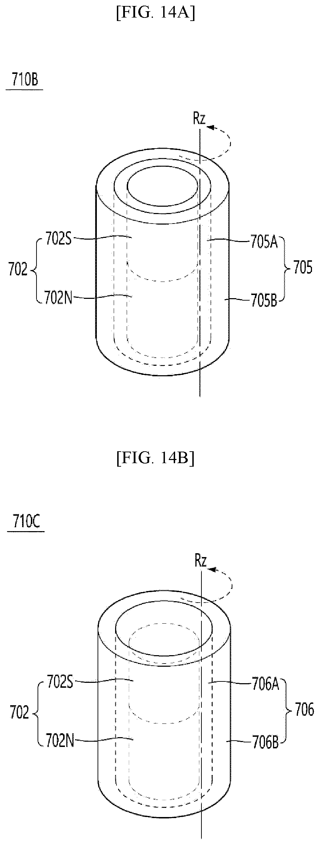

Next, FIG. 14A is a perspective view of the second magnet unit 710B in the embodiment, and the second magnet unit 710B can adopt the technical features of the first magnet unit 710 described above.

The second magnet unit 710B can include a magnet body 702 and a second magnet control unit 705.

The second magnet control unit 705 can include a second magnet focusing unit 705B coupled to the magnet body 702 and a second spacer 705A disposed between the magnet body 702 and the second magnet focusing unit 705B.

The second magnet control unit 705 can be disposed below and above the magnet body 702. For example, the second magnet control unit 705 can be disposed in a form surrounding the N pole part 702N and the S pole part 702S of the magnet body 702, but is not limited thereto.

As the second magnet control unit 705 is disposed from the lower side to the upper side of the magnet body 702, the focusing effect of the magnetic field is increased, the distribution of magnetic flux in the horizontal direction can be improved and the area where the magnetic flux in the vertical direction becomes zero (0) can be expanded.

The second magnet focusing unit 705B can be a ring-shaped metal socket made of a material having high magnetic permeability, but is not limited thereto.

The second spacer 705A may be made of a non-metallic material having low magnetic permeability.

Next, FIG. 14B is a perspective view of a magnet unit 710C according to the third embodiment.

The third magnet unit 710C can adopt technical features of the first magnet unit 710 or the second magnet unit 710B described above.

The third magnet unit 710C can include a magnet body 702 and a third magnet control unit 706.

The third magnet control unit 706 can include a third magnet focusing unit 706B fastened to the magnet body 702 and a third spacer 706A disposed between the magnet body 702 and the third magnet focusing unit 706B.

The third magnet control unit 706 can be disposed higher than the lower and upper sides of the magnet body 702. For example, the third magnet control unit 706 can be disposed to extend higher than the side surfaces of the N pole part 702N and the S pole part 702S of the magnet body 702, but is not limited thereto.

As the third magnet control unit 706 extends from the lower side of the magnet body 702 to the upper side and upper side, further increasing the focusing effect of the magnetic field, it is possible to improve the distribution of magnetic flux in the horizontal direction and further expand the area where the magnetic flux in the vertical direction becomes zero (0).

The third magnet focusing unit 706B can be a ring-shaped metal socket made of a material having high magnetic permeability, but is not limited thereto.

The third spacer 706A may be made of a non-metallic material having low magnetic permeability.

According to the embodiment, the magnet unit can include any one of the first magnet control unit 704 to the third magnet control unit 706.

Accordingly, there is a special technical effect that can improve the speed of moving and assembling a group of semiconductor light emitting device chips by 2 to 3 times compared to internal technology by controlling the direction of the magnetic flux of the magnetic field applied to the semiconductor light emitting device chip.

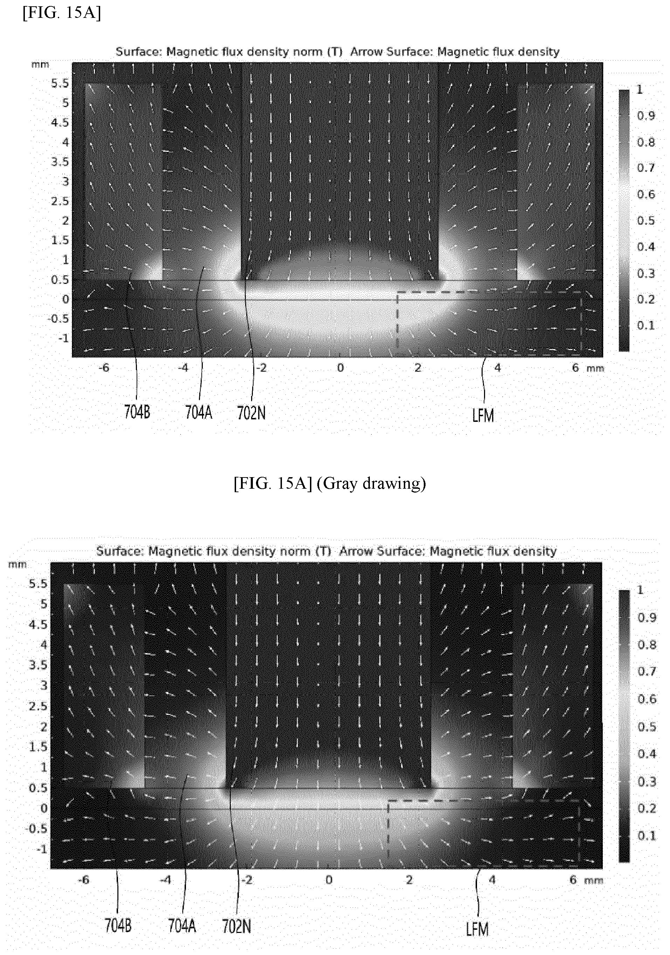

Hereinafter, technical effects according to the embodiment will be described in detail with reference to FIGS. 15A to 17.

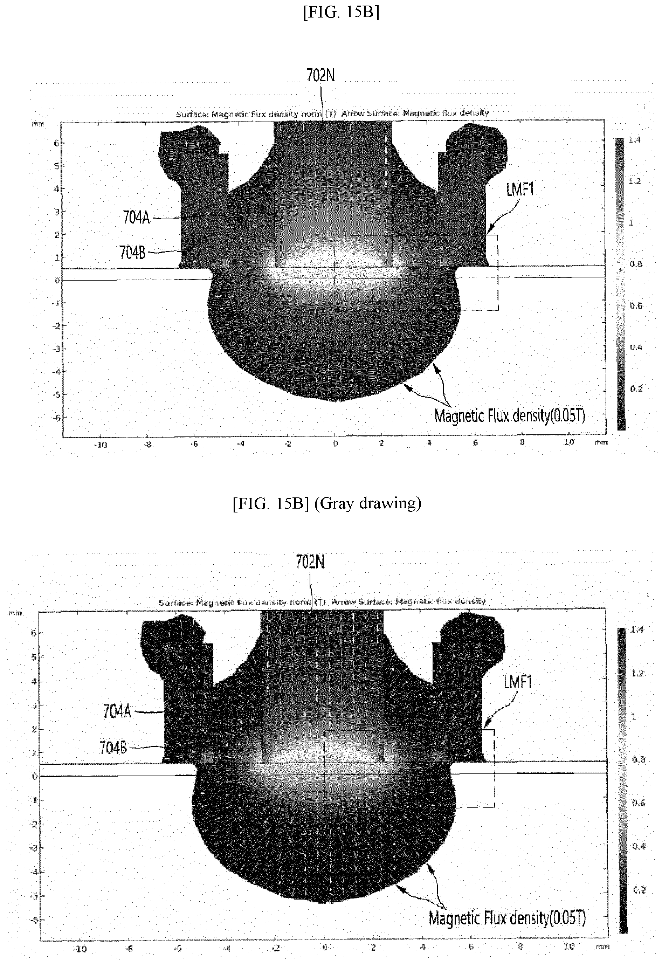

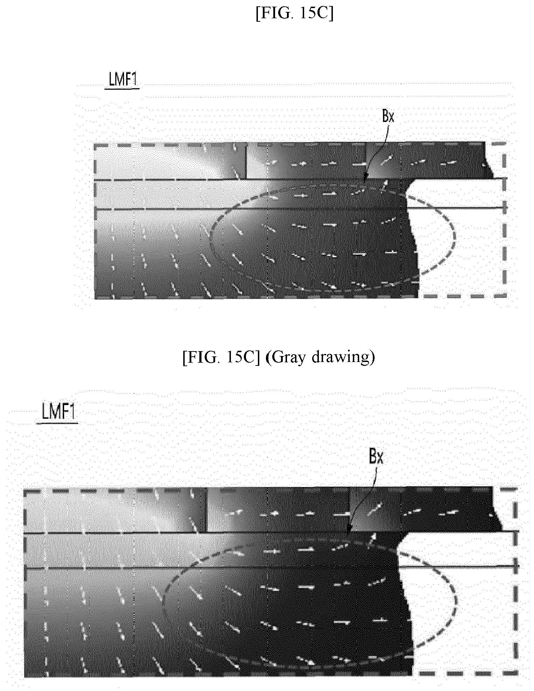

FIG. 15A is magnetic flux density data in the first magnet unit 710 shown in FIG. 12. FIG. 15B is magnetic flux density data of a predetermined magnetic flux density range corresponding to the size of the cluster in the magnet device 600 shown in FIGS. 12 and 15A. FIG. 15C is an enlarged view of the first horizontal magnetic flux area LMF1 in FIG. 15B.

Specifically, FIG. 15B is a graph of magnetic flux density data for an area in which the magnetic flux density is about 0.05 T in the magnet device 600 shown in FIG. 15A.

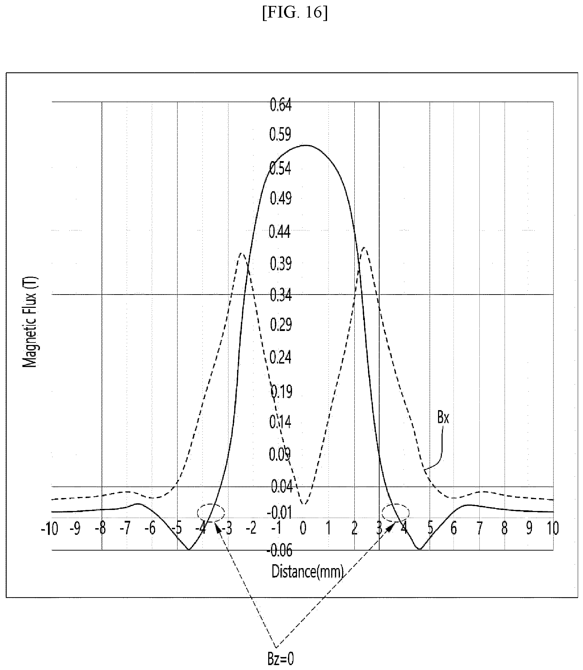

FIG. 16 is a graph of vertical and horizontal magnetic flux densities in the magnet device 600 shown in FIGS. 12 and 15A.

Specifically, FIG. 16 is a graph of magnetic flux density (Bz) in the Z-axis direction (vertical direction) and magnetic flux density (Bx) in the horizontal direction among magnetic flux densities in the magnet device 600 shown in FIG. 15A.

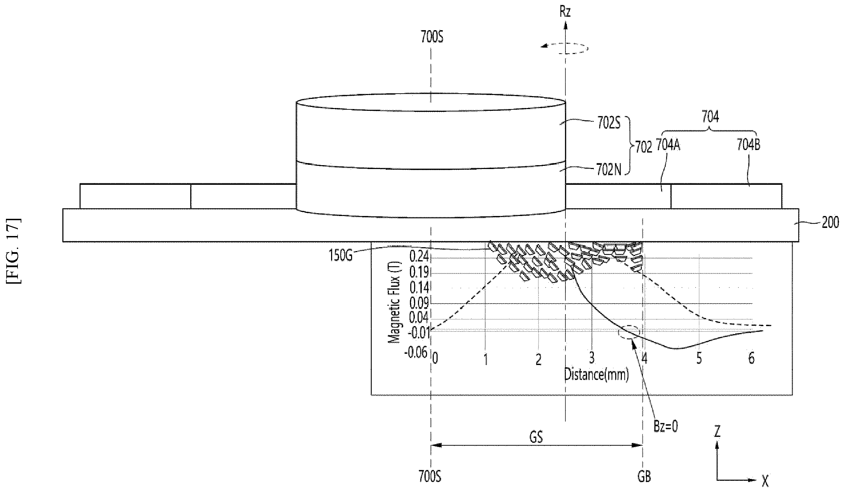

Also, FIG. 17 is a conceptual diagram illustrating rotation of a magnet unit and distribution and movement of a group of semiconductor light emitting devices in the device 1000 for assembly semiconductor light emitting devices for display pixels according to an exemplary embodiment.

Referring to FIG. 12 for a moment, in an embodiment, the first magnet unit 710 can include a magnet body 702 and a first magnet control unit 704.

The first magnet control unit 704 can include a first magnet focusing unit 704B coupled to the magnet body 702 and a first spacer 704A disposed between the magnet body 702 and the first magnet focusing unit 704B.

Referring again to FIG. 15A, in the embodiment, as the magnet unit 710 includes a first magnet focusing unit 704B fastened to the magnet body 702, and a first spacer 704A disposed between the magnet body 702 and the first magnet focusing unit 704B, the direction of the magnetic flux applied to the semiconductor light emitting device chip can be controlled in the horizontal direction (LFM), so there is a special technical effect that can improve the speed of moving and assembling a group of semiconductor light emitting device chips by 2 to 3 times compared to internal technology.

For example, FIG. 15B is a graph of magnetic flux density data for an area in which the magnetic flux density is about 0.05T in the magnet device 600 of the embodiment.

FIG. 15C is an enlarged view of the first horizontal magnetic flux area LMF1 in FIG. 15B.

Referring to FIGS. 15B and 16, according to the embodiment, in the magnet device 600 of the embodiment, a first horizontal magnetic flux area LMF1 in which a vertical magnetic field Bz becomes zero (0) within a predetermined magnetic flux density range corresponding to the size of the cluster of semiconductor light emitting devices can be formed.

In the first horizontal magnetic flux area LMF1, the vertical magnetic field Bz is zero (0), and may be an area where the horizontal magnetic flux Bx mainly exists.

Referring to FIG. 17, in the embodiment, as the magnet unit 710 includes a first magnet focusing unit 704B fastened to the magnet body 702, and a first spacer 704A disposed between the magnet body 702 and the first magnet focusing unit 704B, the size GS of the semiconductor light emitting device cluster can be controlled by controlling the direction of the magnetic flux of the magnetic field applied to the semiconductor light emitting device chip in the horizontal direction (LFM) to clarify the boundary GB of the light emitting device cluster.

For example, according to the embodiment, by forming a first horizontal magnetic flux area LMF1 in which the magnetic field Bz in the vertical direction becomes zero (0) within a predetermined magnetic flux density range corresponding to the size of the cluster of semiconductor light emitting devices in the magnet device 600 of the embodiment, the boundary GB of the cluster of light emitting devices can be clarified and the size GS of the cluster of semiconductor light emitting devices can be controlled.

For example, in FIG. 17, there is a moment when Bz (perpendicular magnetic field) rapidly decreases to 0 in the boundary area between the first magnet focusing unit 704B and the first spacer 704A, this can mean that an area in which only Bx (horizontal magnetic field) can be existed.

Accordingly, in the embodiment, the size GS of the semiconductor light emitting device cluster can be controlled by the size of the first spacer 704A.

According to the embodiment, there is a technical effect of improving assembly efficiency and omitting a separate LED chip collection process by preventing the generation of residual LED chips out of the LED chip cluster formed by the rotating magnet.

Also, according to the embodiment, since the magnet unit 710 includes a first magnet focusing unit 704B fastened to the magnet body 702, a first spacer 704A disposed between the magnet body 702 and the first magnet focusing unit 704B, by controlling the direction of the magnetic flux of the magnetic field applied to the semiconductor light emitting device chips in the horizontal direction (LFM), the arrangement state of the semiconductor light emitting device within the semiconductor light emitting device chip cluster can be controlled in parallel to the assembly substrate.

For example, according to the embodiment, in the magnet device 600 of the embodiment, a first horizontal magnetic flux area LMF1 in which a vertical magnetic field Bz becomes zero (0) within a predetermined magnetic flux density range corresponding to the size of the cluster of semiconductor light emitting devices can be formed. Accordingly, the embodiment has a special technical effect that can significantly improve the tablet assembly efficiency in the assembly hole and improve the tablet assembly speed by 2 to 3 times or more compared to the internal technology.

For example, according to the embodiment, since the magnetic layer of the semiconductor light emitting device can take a horizontal shape with respect to the assembly hole rather than the shape in which the semiconductor light emitting device chip is vertically erected in the assembly hole of the assembly substrate due to the distribution of the magnetic field, the assembly rate of the semiconductor light emitting device chip can be remarkably improved by the DEP force.

Also, according to the embodiment, by controlling the direction of the magnetic flux of the magnetic field applied to the semiconductor light emitting device chips in the horizontal direction (LFM), the arrangement state of the semiconductor light emitting devices in the semiconductor light emitting device chip cluster can be controlled in parallel with the assembly substrate.

Therefore, the embodiment has a special technical effect of improving the movement speed of the semiconductor light emitting device chip group by 2 to 3 times or more compared to the internal technology by lowering the resistance to the fluid and the assembly substrate.

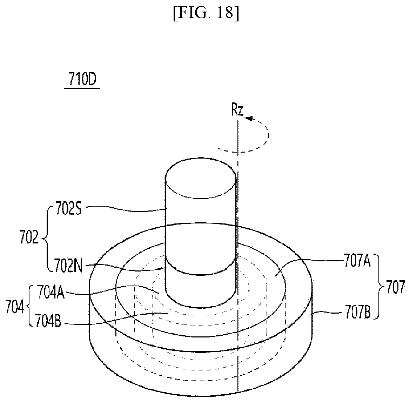

FIG. 18 is a perspective view of a fourth magnet unit 710D in the device 1000 for assembling a semiconductor light emitting device for a display pixel according to an exemplary embodiment.

The fourth magnet unit 710D can adopt the technical features of the first to third magnet units 710 to 710C described above, and hereinafter, the main characteristics of the fourth magnet unit 710D will be mainly described.

The fourth magnet unit 710D can include a magnet body 702, a first magnet control unit 704, and a fourth magnet control unit 707.

The first magnet control unit 704 can be disposed on the outer circumference of the magnet body 702, and the fourth magnet control unit 707 can be disposed on the outer circumference of the first magnet control unit 704.

For example, the fourth magnet control unit 707 can include a fourth magnet focusing unit 707B disposed around the outer circumference of the first magnet control unit 704 and a fourth spacer 707A disposed between the first magnet control unit 704 and the fourth magnet focusing unit 707B.

The fourth magnet focusing unit 707B may be a ring-shaped metal socket made of a material having high magnetic permeability, but is not limited thereto. The fourth spacer 707A can be made of a non-metallic material having low magnetic permeability.

The fourth magnet focusing unit 707B can have a higher permeability than the first magnet focusing unit 704B. Alternatively, the width of the fourth magnet focusing unit 707B can be greater than that of the first magnet focusing unit 704B.

According to the embodiment, as the fourth magnet focusing unit 707B controls permeability or width to be higher than that of the first magnet focusing unit 704B, there is a special technical effect that can be adjusted to minimize the absolute Bz (z-direction magnetic field) at the bottom of the assembly substrate 200.

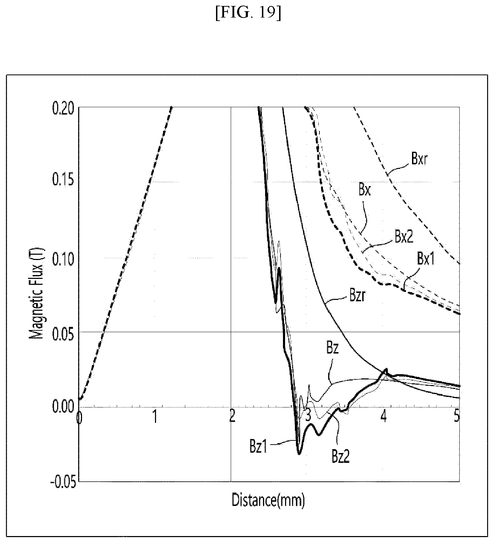

Hereinafter, the technical effect of the fourth magnet unit 710D will be described in detail with reference to FIGS. 19 to 20B.

FIG. 19 is a graph of vertical and horizontal magnetic flux densities in Examples and Comparative Examples adopting the fourth magnet unit 710D.

Specifically, FIG. 19 includes data of magnetic flux density (Bzr) in the Z-axis direction and magnetic flux density (Bxr) in the horizontal direction in the magnet unit (refer to FIG. 8) of the comparative example, which is an internal technique.

Also, FIG. 19 includes data of magnetic flux density (Bz) in the Z-axis direction and magnetic flux density (Bx) in the horizontal direction in the first magnet unit 710 shown in FIG. 12.

Also, FIG. 19 includes data of magnetic flux densities (Bz1, Bz2) in the Z-axis direction and magnetic flux densities (Bx1, Bx2) in the horizontal direction among the magnetic flux densities in the fourth magnet unit 710D shown in FIG. 18.

Specifically, FIG. 19 includes data of magnetic flux density (Bz1) in the Z-axis direction and magnetic flux density (Bx1) in the horizontal direction in the first magnet focusing unit 704B of the fourth magnet unit 710D shown in FIG. 18.

Also, FIG. 19 includes data of magnetic flux density (Bz2) in the Z-axis direction and magnetic flux density (Bx2) in the horizontal direction in the fourth magnet focusing unit 707B of the fourth magnet unit 710D shown in FIG. 18.

Fourth magnet focusing unit 707B according to the embodiment controls the magnetic flux density Bz2 in the Z-axis direction at the lower portion of the assembly substrate 200 to be minimized by controlling its permeability or width to be higher than that of the first magnet focusing unit 704B, there is a special technical effect of significantly improving assembly speed and assembly efficiency by controlling the direction of the magnetic flux applied to the semiconductor light emitting device chip in the horizontal direction more effectively to control the arrangement state of the semiconductor light emitting device in parallel with the assembly substrate.

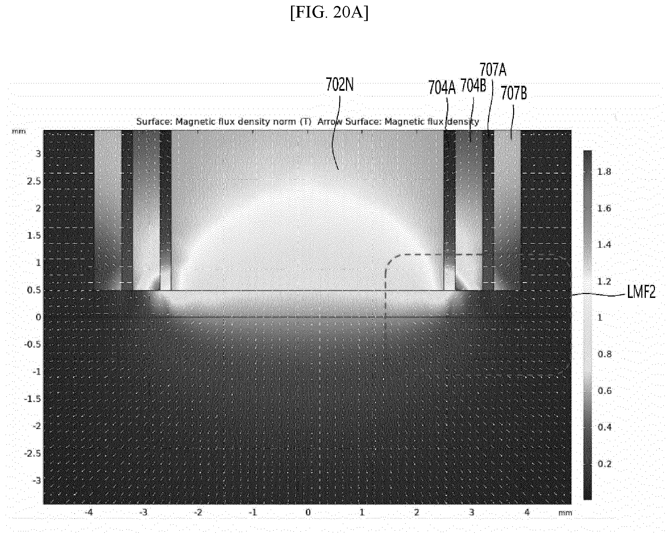

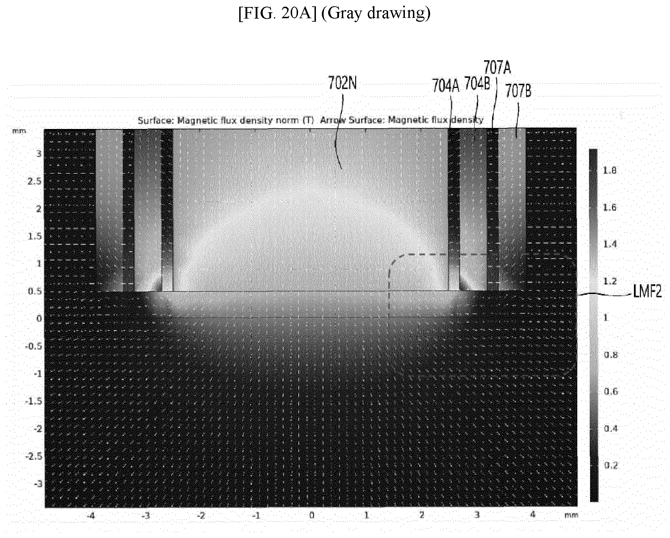

Specifically, FIG. 20A is magnetic flux density data in the fourth magnet unit 710D shown in FIG. 18.

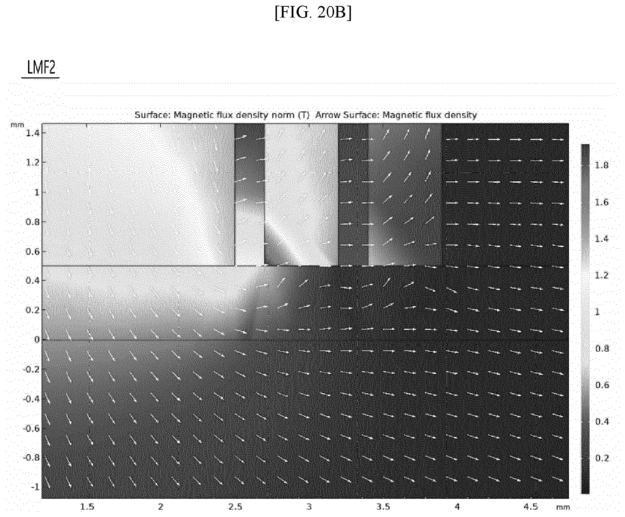

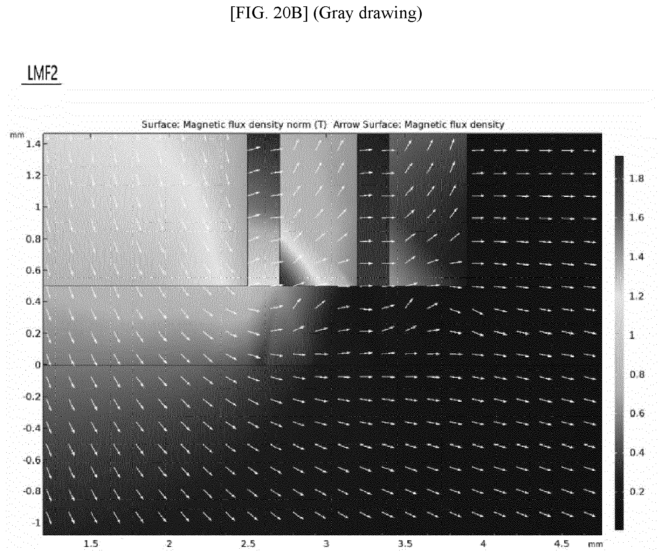

FIG. 20B is an enlarged view of the second horizontal magnetic flux area LMF2 in FIG. 20A.

Referring to FIGS. 20A and 20B, the magnet device of the embodiment can form a second horizontal magnetic flux area LMF2 in which a vertical magnetic field Bz becomes zero (0) within a predetermined magnetic flux density range corresponding to the size of the cluster of semiconductor light emitting devices.

In the embodiment, as the fourth magnet unit 710D controls the permeability or width of the fourth magnet focusing unit 707B of the fourth magnet control unit 707 to be larger than that of the first magnet focusing unit 704B, there is a special technical effect that can be adjusted to minimize the absolute Bz (z-direction magnetic field) at the bottom of the assembly substrate 200.

For example, the fourth magnet focusing unit 707B according to the embodiment controls the magnetic flux density Bz2 in the Z-axis direction at the lower portion of the assembly substrate 200 to be minimized by controlling its magnetic permeability or width to be higher than that of the first magnet focusing unit 704B, and the direction of the magnetic flux of the magnetic field applied to the semiconductor light emitting device chip is more effectively controlled in the horizontal direction to form a wider second horizontal magnetic flux area (LMF2) in which the magnetic field (Bz) in the vertical direction becomes zero (0), so the arrangement state of the semiconductor light emitting device can be controlled in parallel with the assembly substrate. Therefore, there is a special technical effect of remarkably improving assembly speed and assembly efficiency.

## Claims

1. A magnet unit of a semiconductor light emitting device for a display pixel, the magnet unit comprising:
a magnet body; and
a magnet control unit disposed on an outer circumference of the magnet body,
wherein the magnet control unit comprises a first magnet focusing unit spaced apart from the outer circumference of the magnet body and a first spacer disposed between the magnet body and the first magnet focusing unit.

2. The magnet unit according to claim 1, wherein the magnet control unit is disposed at a lower portion of the magnet body.

3. The magnet unit according to claim 1, or 2, wherein the first magnet focusing unit comprises at least ferrite, nickel, iron, cobalt, or nickel-cobalt alloy.

4. The magnet unit according to claim 1, 2, or 3, wherein the spacer comprises at least one of a plastic material, a fiber material, or a wood material.

5. The magnet unit according to any one of claims 1 to 4, wherein the magnet control unit is disposed around lower and upper portions of the magnet body.

6. The magnet unit according to any one of claims 1 to 5, wherein the magnet control unit extends higher than a top of the magnet body.

7. The magnet unit according to any one of claims 1 to 6, further comprising a double magnet control unit disposed on an outer circumference of the magnet control unit.

8. The magnet unit according to claim 7, wherein the double magnet control unit includes a double magnet focusing unit spaced apart from the outer circumference of the magnet control unit and a double spacer disposed between the magnet control unit and the double magnet focusing unit.

9. A self-assembly device of a semiconductor light emitting device for a display pixel comprising:
a chamber accommodating a fluid and a plurality of semiconductor light emitting devices;
an assembly substrate disposed on the chamber; and
a magnet assembly device disposed on the assembly substrate,
wherein the magnet assembly device comprises a magnet support unit to which a plurality of magnet units are mounted and a magnet rotation unit for rotating the magnet support unit, and
wherein the magnet unit comprises the magnet unit according to any one of claims 1 to 8.

10. The self-assembly device according to claim 9, wherein the magnet control unit is disposed around lower and upper circumferences of the magnet body.

11. The self-assembly device according to claim 9, or 10, wherein the magnet control unit is disposed higher than lower and upper sides of the magnet body.

12. The self-assembly device according to claim 9, 10, or 11, further comprising a double magnet control unit disposed on the outer circumference of the magnet control unit.

13. The self-assembly device according to claim 12, wherein the double magnet control unit includes a double magnet focusing unit spaced apart from the outer circumference of the magnet control unit and a double spacer disposed between the magnet control unit and the double magnet focusing unit.

14. The self-assembly device according to any one of claims 9 to 13, wherein the semiconductor light emitting device is assembled on the assembly substrate vertically overlapping a region between the magnet body and the first magnet focusing unit.

15. The self-assembly device according to any one of claims 9 to 14, wherein the semiconductor light emitting device is assembled on the assembly substrate vertically overlapping the first spacer.
